# EUROPEAN PATENT APPLICATION

(11) **EP 1 761 122 A1**
(43) Date of publication of application: **07.03.2007**
(21) Application number: 06291374.4
(22) Date of filing: 29.08.2006
(51) Int. Cl.: H05K 9/00, G02B 5/20

(54) **Front filter and plasma display panel having the same**

(30) Priority: 30.08.2005 KR 20050080092
(71) Applicant: LG Electronics Inc., Youngdungpo-gu Seoul (KR)
(72) Inventor: Cha, Hong Rae, Seoul (KR)
(74) Representative: Vignesoult, Serge L. M.

(57) **Abstract**

A front filter of a plasma display panel and the grounding of the plasma display panel having the same are disclosed. The front filter of the plasma display panel includes a base film, an anti-reflection film provided at a first surface of the base film, and an electromagnetic wave shielding film provided at a second surface of the base film or on the electromagnetic wave shielding film.

## Description

This application claims the benefit of the Korean Patent Application No. 10-2005-0080092, filed on August 30, 2005, which is hereby incorporated by reference as if fully set forth herein.

### BACKGROUND OF THE INVENTION

### Field of the Invention

The present invention relates to a plasma display panel, and more particularly, to a front filter and a grounding of a plasma display panel having the same.

### Discussion of the Related Art

Generally, a plasma display panel includes upper and lower panels and barrier ribs formed between the upper and lower panels, and the barrier ribs serve to divide electric discharge cells from one another. Each discharge cell is filled with a primary electric discharge gas, such as neon, helium, mixed gas of neon and helium, or the like, and an inert gas containing a small amount of xenon. If an electric discharge occurs by a high-frequency voltage, the inert gas generates vacuum ultraviolet rays to excite phosphors between the barrier ribs, thereby realizing the formation of an image using light emitted from the phosphors. The plasma display panel having the above described configuration is thin and light and therefore, is highlighted as a next generation display device.

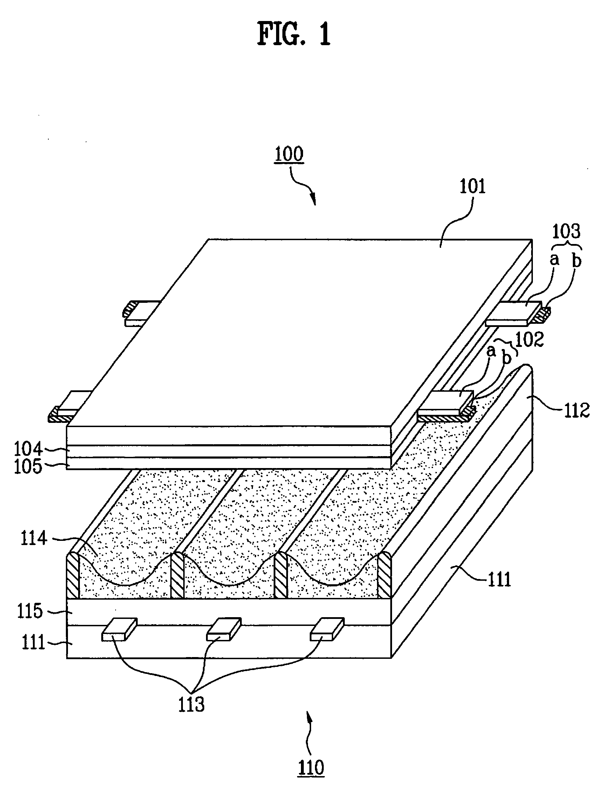

FIG. 1 is a perspective view schematically illustrating the configuration of a plasma display panel. As shown in FIG. 1, the plasma display panel includes an upper panel 100 and a lower panel 110, which are coupled parallel to each other with a predetermined distance therebetween. The upper panel 100 of the plasma display panel includes a plurality of sustain electrode pairs in which scan electrodes 102 and sustain electrodes 103 are formed in pairs. The plurality of sustain electrode pairs are arranged on an upper glass plate 101 serving as a display surface on which images are displayed. The lower panel 110 of the plasma display panel includes a plurality of address electrodes 113 arranged on a lower glass plate 111 to cross the plurality of sustain electrode pairs.

Barrier ribs 112 are arranged parallel to one another on the lower panel 110. The barrier ribs have a stripe form (or well form) for forming a plurality of discharge spaces, i.e. discharge cells. The plurality of address electrodes 113 are disposed parallel to the barrier ribs 112 and adapted to generate vacuum ultraviolet rays via implementation of an address discharge. R, G and B phosphors 114 are applied onto a top surface of the lower panel 110 and adapted to emit visible rays for displaying images during the address discharge. Also, a lower dielectric layer 115 for protecting the address electrodes 113 is formed between the address electrodes 113 and the phosphors 114.

The conventional plasma display panel having the above described configuration is basically manufactured through a glass manufacturing process, upper panel manufacturing process, lower panel manufacturing process and assembling process.

First, the upper panel manufacturing process comprises: forming the scan electrodes and sustain electrodes on the upper glass plate; forming an upper dielectric layer for limiting discharge current of the scan and sustain electrodes and insulating pairs of the scan and sustain electrodes from each other; and forming a protective layer on the upper dielectric layer via deposition of magnesium oxide to facilitate discharge conditions.

The lower panel manufacturing process comprises: forming the address electrodes on the lower glass plate; forming the lower dielectric layer for protecting the address electrodes; forming the barrier ribs at an upper surface of the lower dielectric layer for dividing the discharge cells from one another; and forming a phosphor layer between the barrier ribs for emitting visible rays for the display of images.

The above described plasma display panel is provided, at a front surface thereof, with a front filter. The front filter has functions of shielding electromagnetic waves and near infrared rays, performing color correction, preventing reflection of light incident from the outside, and the like. Conventionally, a glass type front filter, in which a plurality of layers performing the above described functions are laminated on a glass substrate, has been used. The glass type front filter has the effect of preventing damage thereto due to external impacts, but suffers from many problems, such as thick thickness and heavy weight as well as an increase in manufacturing costs.

As a solution of the above described problems, a film type front filter has been proposed in the art. The film type front filter includes a near infrared ray shielding film, electromagnetic wave shielding film, color correction film, anti-reflection film, etc., which are laminated on a base film in this order. The above respective films are bonded to one another by use of an adhesive.

However, the above described plasma display panel has the following problems.

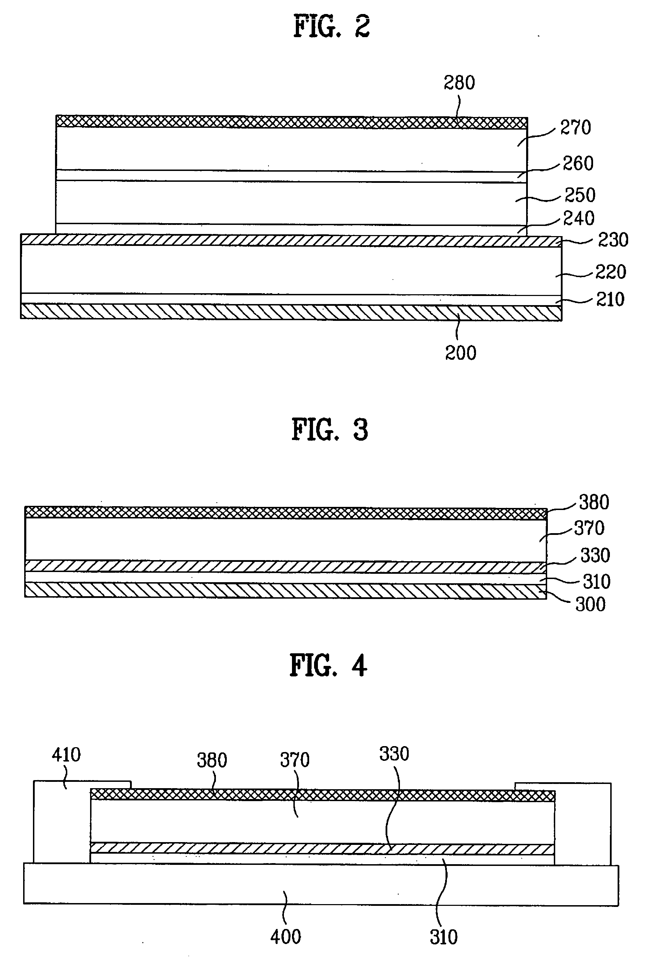

As shown in FIG. 2, a conventional front filter includes an electromagnetic wave shielding film 230, near infrared ray shielding film 260, and anti-reflection film 280 laminated in this order from the bottom. These mentioned films are formed on their respective base films 220, 250, and 270, and are bonded to one another through adhesive layers 240 therebetween. In particular, the base film 220, on which the electromagnetic wave shielding film 230 is formed, is also bonded to a release film 200 through an adhesive layer 210.

In the above described conventional front filter having a multilayer structure, the electromagnetic wave shielding film 230 has an area wider than those of the other films, and a peripheral edge of the electromagnetic wave shielding film 230 is grounded to a plasma display panel module, to form a bus-bar.

Since the conventional front filter is manufactured to have the plurality of layers, accordingly, the resulting conventional plasma display panel exhibits a complicated manufacturing process and thus, causes deterioration in yield as well as increased manufacturing costs. That is, under the condition that each unit film is formed on the associated exclusive base film, the front filter consequently should have a plurality of base films.

To solve the above problem, although it has been attempted to manufacture a front filter having a single layer structure, this solution has a difficulty to obtain the grounding of the front filter with the prior art grounding technologies.

### SUMMARY OF THE INVENTION

Accordingly, the present invention is directed to a front filter, plasma display panel having the same and manufacturing method therefor that substantially obviate one or more problems due to limitations and disadvantages of the related art.

An object of the present invention is to provide a plasma display panel including a front filter formed on a single base film, and a method for manufacturing the same.

Another object of the present invention is to provide a grounding structure and grounding method of a front filter having a single layer structure.

Additional advantages, objects, and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

To achieve these objects and other advantages and in accordance with the purpose of the invention, as embodied and broadly described herein, a front filter of a plasma display panel comprises a base film, an anti-reflection film provided at a first surface of the base film, and an electromagnetic wave shielding film provided at a second surface of the base film.

In accordance with another aspect of the present invention, there is provided a plasma display panel comprising upper and lower panels bonded to face each other with barrier ribs therebetween and a front filter formed on the upper panel, the plasma display panel further comprising: a conductive paste provided around a side surface of the front filter and connected to a ground wire.

In accordance with a further aspect of the present invention, there is provided a plasma display panel comprising: upper and lower panels bonded to face each other with barrier ribs therebetween: and a film type front filter formed on the upper panel, the front filter comprising a base film, an anti-reflection film provided at a first surface of the base film, and an electromagnetic wave shielding film provided at a second surface of the base film.

In accordance with a still another aspect of the present invention, there is provided a front filter of a plasma display panel comprising: a base film; an electromagnetic wave shielding film provided at a first surface of the base film; and an anti-reflection film provided on the electromagnetic wave shielding film.

In accordance with yet another aspect of the present invention, there is provided a plasma display panel comprising: upper and lower panels bonded to face each other with barrier ribs therebetween: and a film type front filter formed on the upper panel, the front filter comprising a base film, an electromagnetic wave shielding film provided at a front surface of the base film, and an anti-reflection film provided on the electromagnetic wave shielding film.

It is to be understood that both the foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings:

FIG. 1 is a perspective view illustrating a conventional plasma display panel;

FIG. 2 is a sectional view illustrating a conventional front filter;

FIG. 3 is a sectional view illustrating a front filter of a plasma display panel according to a first embodiment of the present invention;

FIG. 4 is a sectional view illustrating a grounding method of the front filter according to the first embodiment of the present invention;

FIG. 5 is a sectional view illustrating a front filter of a plasma display panel according to a second embodiment of the present invention;

FIG. 6 is a sectional view illustrating a grounding method of the front filter according to the second embodiment of the present invention;

FIG. 7 is a sectional view illustrating a front filter of a plasma display panel according to a third embodiment of the present invention;

FIG. 8 is a sectional view illustrating a grounding method of the front filter according to the third embodiment of the present invention;

FIG. 9 is a sectional view illustrating a front filter of a plasma display panel according to a fourth embodiment of the present invention; and

FIG. 10 is a sectional view illustrating a grounding method of the front filter according to the fourth embodiment of the present invention.

### DETAILED DESCRIPTION OF THE INVENTION

Reference will now be made in detail to the preferred embodiments of the present invention, examples of which are illustrated in the accompanying drawings. Wherever possible, the same reference numbers will be used throughout the drawings to refer to the same or like parts.

A plasma display panel according to the present invention has a feature in that a protective layer thereof includes functional films, such as an electromagnetic wave shielding film, etc., formed on a single base film, and a conductive paste is applied to be connected to the electromagnetic wave shielding film, so as to form a bus-bar, i.e. ground region.

FIG. 3 is a sectional view illustrating a front filter of a plasma display panel according to a first embodiment of the present invention, and FIG. 4 is a sectional view illustrating a grounding method of the front filter according to the first embodiment of the present invention. Now, the plasma display panel and front filter thereof according to the first embodiment of the present invention will be explained with reference to FIGs. 3 and 4.

As shown in FIG. 3, the front filter according to the first embodiment of the present invention has a feature in that an anti-reflection film 380 and electromagnetic wave shielding film 330 are formed at opposite surfaces of a base film 370, respectively. The base film 370 is formed of a PET film, or the like. The anti-reflection film 380 is able to prevent reflection of light incident from the outside and consequently, to prevent glare from a screen. The electromagnetic wave shielding film 330 is formed by patterning a conductive material to have a stripe or mesh form, or the like, and serves to shield electromagnetic waves being emitted to the outside of the panel.

Preferably, the electromagnetic wave shielding film 330 is bonded to a release film 300 through an adhesive layer 310. The adhesive layer may be made of a pressure sensitive adhesive (PSA), etc. Although not shown in FIG. 3, additionally, a cover film may be formed on the anti-reflection film 380. The above mentioned release film 300 and cover film serve to protect or support the front filter, and preferably, are removed in the course of attaching the front filter to an upper glass plate of a plasma display panel. Also, the adhesive layer 310 preferably contains a dye for shielding near infrared rays (NIRs) and correcting colors.

Specifically, in the above described first embodiment, the electromagnetic wave shielding film and anti-reflection film are formed at first and second surfaces of the single base film 370, respectively, and the adhesive layer contains a dye having near infrared ray shielding and color correction functions. Although the present embodiment describes a film type front filter, a glass type front filter may be manufactured by using glass instead of the base film, and this is the same as in the following other embodiments. Also, it should be understood that an area of the front filter is smaller than that of the upper glass plate of the plasma display panel, but is larger than that of an effective display surface.

FIG. 4 illustrates a part of the plasma display panel to which the above described front filter according to the first embodiment of the present invention is bonded. The electromagnetic wave shielding film 330 is bonded onto an upper glass plate 400 through the adhesive layer 310, and the base film 370 and anti-reflection film 380 are successively laminated on the electromagnetic wave shielding film 330. That is, by removing the release film 300 from the above described front filter of the first embodiment, the front filter is able to be bonded onto the upper glass plate 400. For the sake of grounding, a conductive paste 410 is applied to perform the grounding of the electromagnetic wave shielding film 330. As shown in FIG. 4, the conductive paste 410 is formed on the upper glass plate 400, and more particularly, is formed around a side surface of the front filter. Also, the conductive paste 410 is bonded to the front filter and therefore, as shown, covers an outer peripheral region of an upper surface of the anti-reflection film 380 by a certain width. For example, if a plane of the front filter has a square shape, the conductive paste covers an outer peripheral region of the square. The configurations of the remaining portions of the plasma display panel except for the above described upper glass plate 400 are the same as those of the prior art, and are the same as in the following other embodiments.

Here, a region where the conductive paste 410 is bonded to the electromagnetic wave shielding film 330 forms a bus-bar. That is, the conductive paste 410 is connected to a panel module to perform a grounding function.

With this configuration, accordingly, it is possible not only to manufacture a front filter by use of a single base film, but also to form a bus-bar only via application of the conductive paste without using separate metal wires, etc. for the purpose of grounding.

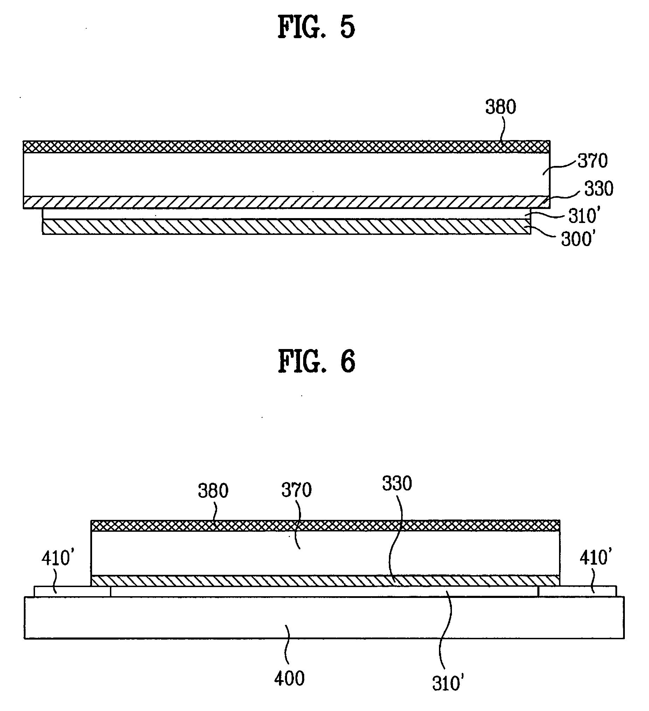

FIG. 5 is a sectional view illustrating a front filter of a plasma display panel according to a second embodiment of the present invention, and FIG. 6 is a sectional view illustrating a grounding method of the front filter according to the second embodiment of the present invention. Now, the plasma display panel and front filter thereof according to the second embodiment of the present invention will be explained with reference to FIGs. 5 and 6.

Although the front filter of the second embodiment is basically similar to that of the above described first embodiment, the front filter of the second embodiment has a feature in that an adhesive layer 310' and release film 300' have an area smaller than that of the electromagnetic wave shielding film 330, etc. Specifically, the anti-reflection film 380 and electromagnetic wave shielding film 330 may be formed at opposite surfaces of the base film 370, respectively, and all the above mentioned films 380, 330 and 370 may have the same area as one another. However, preferably, the area of the adhesive layer 310' is smaller than that of the electromagnetic wave shielding film 330, and the release film 300' to be bonded to the adhesive layer 310' has the same area as that of the adhesive layer 310'. Here, the composition of the adhesive layer 310' is the same as in the above described first embodiment.

FIG. 6 illustrates a part of the plasma display panel to which the above described front filter of the second embodiment is bonded. Although the plasma display panel shown in FIG. 6 is basically similar to that of the plasma display panel shown in FIG. 4, the plasma display panel employs a slightly different grounding method from that of the first embodiment, on the basis of the configuration of the relevant front filter.

Specifically, in the front filter bonded onto the upper glass plate 400, there are features in that an area of the adhesive layer 310' thereof is smaller than that of the electromagnetic wave shielding film 330, and thus, a space having a U-shaped longitudinal section is defined by the electromagnetic wave shielding film 330, adhesive layer 310', and upper glass plate 400. A conductive paste 410' is formed in the U-shaped space by injection. Accordingly, the conductive paste 410' is bonded to a part of a lower surface of the electromagnetic wave shielding film 330 to thereby be grounded. That is, a bus-bar is formed at an outer peripheral region of the lower surface of the electromagnetic wave shielding film 330.

In the present embodiment, a grounding area of the electromagnetic wave shielding film is larger than that of the above described first embodiment, and this enables more stable formation of a ground region.

Hereinafter, a method for bonding one of the front filters according to the first and second embodiments to the plasma display panel, and more particularly, a method for manufacturing the plasma display panel having one of the above described front filters will be explained.

First, the above described front filter of the first embodiment is manufactured. Specifically, the electromagnetic wave shielding film and anti-reflection film are formed at opposite surfaces of the base film, and subsequently, the release film and/or protective film is bonded by use of the adhesive layer.

After removing the release film, the front filter is bonded onto the upper glass plate of the plasma display panel. In this case, if the front filter is rolled by use of a roller, etc. to receive a slight pressure, the front filter is bonded onto the upper glass plate by an adhesion force of the adhesive layer. After completion of the rolling, the protective film and adhesive layer bonded thereto, etc. are removed.

Subsequently, the conductive paste is applied onto the upper glass plate to ground a side surface of the electromagnetic wave shielding film. If the conductive paste is dried, a process for forming a bus-bar is completed. If the above described front filter of the second embodiment is used, there is a difference in that the conductive paste is injected into the U-shaped space defined by the electromagnetic wave shielding film, adhesive layer and upper glass plate.

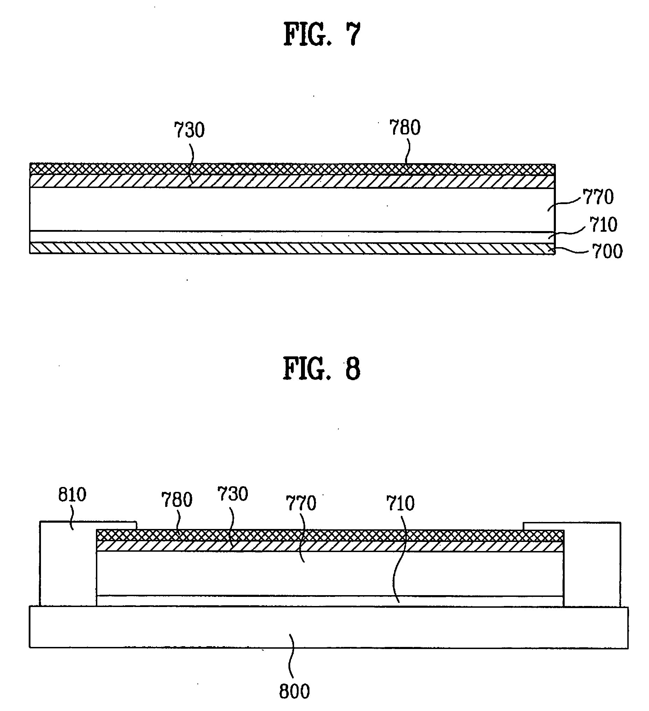

FIG. 7 is a sectional view illustrating a front filter of a plasma display panel according to a third embodiment of the present invention, and FIG. 8 is a sectional view illustrating a grounding method of the front filter according to the third embodiment of the present invention. Now, the plasma display panel and front filter thereof according to the third embodiment of the present invention will be explained with reference to FIGs. 7 and 8.

Although the front filter of the present embodiment is basically similar to that of the above described first embodiment, there is a difference in the lamination order of respective functional films. Specifically, an electromagnetic wave shielding film 730 and anti-reflection film 780 are formed on one surface of a base film 770 in this order. In this case, since the electromagnetic wave shielding film 730 and anti-reflection film 780 come into direct contact with each other, the electromagnetic wave shielding film 730 is preferably formed by a sputtering process rather than being patterned. A release film 700 is bonded to the other surface of the base film 770 through an adhesive layer 710. That is, the present embodiment employs different formation position and method of the electromagnetic wave shielding film 730 from those of the above described first embodiment.

FIG. 8 illustrates a part of the plasma display panel in sectional view, to which the above described front filter of the third embodiment is bonded. The base film 770 is bonded onto an upper glass plate 800 through the adhesive layer 710, and the electromagnetic wave shielding film 730 and anti-reflection film 780 are formed on the base film 770 in this order. A conductive paste 810 is formed on the upper glass plate 800 around a side surface of the front filter. Accordingly, the conductive paste 810 is electrically connected to a side surface of the electromagnetic wave shielding film 730, to form a ground region, i.e. bus-bar. It is reasonable that the above described conductive paste 810 is connected to a panel module through a ground wire.

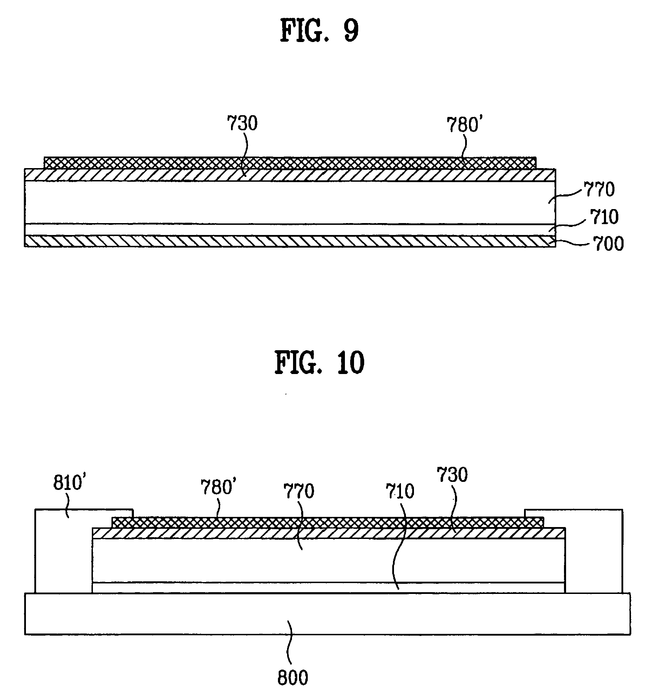

FIG. 9 is a sectional view illustrating a front filter of a plasma display panel according to a fourth embodiment of the present invention, and FIG. 10 is a sectional view illustrating a grounding method of the front filter according to the fourth embodiment of the present invention. Now, the plasma display panel and front filter thereof according to the fourth embodiment of the present invention will be explained with reference to FIGs. 9 and 10.

Although the fourth embodiment is basically similar to the above described third embodiment, it has a feature in that an area of an anti-reflection film 780' is smaller than that of the electromagnetic wave shielding film 730, etc. This configuration is efficient to achieve an easy and stable grounding of the electromagnetic wave shielding film 730 as will be described hereinafter. The composition of respective functional films is the same as those of the above described embodiments.

FIG. 10 illustrates a part of the plasma display panel to which the above described front filter of the fourth embodiment is bonded. Although the plasma display panel shown in FIG. 10 is basically similar to the plasma display panel shown in FIG. 8, the plasma display panel of the present embodiment employs a slightly different grounding method from that of the third embodiment, on the basis of the configuration of the relevant front filter.

Specifically, in the front filter bonded onto the upper glass plate 800, there is a feature in that an area of the anti-reflection film 780' is smaller than that of the electromagnetic wave shielding film 730. Since a conductive paste 810' is formed around a side surface of the front filter, a ground region, i.e. bus-bar is formed on a part of an exposed upper surface of the electromagnetic wave shielding film 730 as well as around the side surface of the film 730. Accordingly, an area of the bus-bar according to the present invention is larger than that of the third embodiment shown in FIG. 8, resulting in easy and stable formation of the bus-bar.

A method for bonding one of the front filters according to the third and fourth embodiments to the plasma display panel, and more particularly, a method for manufacturing the plasma display panel having one of the above described front filters is approximately the same as those of the first and second embodiments.

First, after manufacturing the front filter, the release film is removed and the front filter is compressed onto the upper glass plate by use of a roller. Then, the protective film is removed, and the conductive paste is applied and dried. In the method according to the third and fourth embodiments, it should be noted that the bus-bar is formed above the base film.

In the above described embodiments of the plasma display panel, the configurations of the other constituent elements except for the front filter and ground region are the same as those of the prior art. Also, the front filter may be a glass type front filter rather than being the above described film type front filter, and the electromagnetic wave shielding film, etc. may be directly formed on an upper glass plate of the plasma display panel.

It will be apparent to those skilled in the art that various modifications and variations can be made in the present invention without departing from the spirit or scope of the inventions. Thus, it is intended that the present invention covers the modifications and variations of this invention provided they come within the scope of the appended claims and their equivalents.

## Claims

1. A front filter of a plasma display panel comprising:
a base film;
an anti-reflection film provided at a first surface of the base film; and
an electromagnetic wave shielding film provided at a second surface of the base film.

2. The front filter according to claim 1, further comprising:
an adhesive layer provided on the electromagnetic wave shielding film for bonding the electromagnetic wave shielding film to a release film.

3. The front filter according to claim 2, wherein the adhesive layer contains a dye for shielding near infrared rays and correcting colors.

4. The front filter according to claim 2, wherein the adhesive layer has a smaller area than that of the electromagnetic wave shielding film.

5. A plasma display panel comprising upper and lower panels bonded to face each other with barrier ribs therebetween and a front filter formed on the upper panel, further comprising:
a conductive paste provided around a side surface of the front filter and connected to a ground wire.

6. The plasma display panel according to claim 5,
wherein the front filter comprises a base film, an anti-reflection film provided at a first surface of the base film, and an electromagnetic wave shielding film provided at a second surface of the base film, and
wherein the conductive paste is bonded to a side surface of the electromagnetic wave shielding film, to form a bus-bar.

7. The plasma display panel according to claim 6, further comprising:
an adhesive layer provided between the electromagnetic wave shielding film and the upper panel.

8. The plasma display panel according to claim 7, wherein the adhesive layer contains a dye for shielding near infrared rays and correcting colors.

9. The plasma display panel according to claim 7,
wherein the adhesive layer has a smaller area than that of the electromagnetic wave shielding film, and
wherein the conductive paste is bonded to a lower surface of the electromagnetic wave shielding film, to form the bus-bar.

10. The plasma display panel according to claim 5,
wherein the front filter comprises a base film, and an electromagnetic wave shielding film and anti-reflection film provided at a first surface of the base film, and
wherein the conductive paste is bonded to a side surface of the electromagnetic wave shielding film, to form a bus-bar.

11. The plasma display panel according to claim 10, wherein the electromagnetic wave shielding film is formed by a sputtering process.

12. The plasma display panel according to claim 10, further comprising:
an adhesive layer formed at a second surface of the base film.

13. The plasma display panel according to claim 12, wherein the adhesive layer contains a dye for shielding near infrared rays and correcting colors.

14. The plasma display panel according to claim 10,
wherein the anti-reflection film has a smaller area than that of the electromagnetic wave shielding film, and
wherein the conductive paste is bonded to a side surface and upper surface of the electromagnetic wave shielding film, to form a bus-bar.

15. A plasma display panel comprising:
upper and lower panels bonded to face each other with barrier ribs therebetween: and
a film type front filter formed on the upper panel, the front filter comprising a base film, an anti-reflection film provided at a first surface of the base film, and an electromagnetic wave shielding film provided at a second surface of the base film.

16. The plasma display panel according to claim 15,
wherein the base film is made of glass, and the front filter is a glass type front filter.

17. A front filter of a plasma display panel comprising:
a base film;
an electromagnetic wave shielding film provided at a first surface of the base film; and
an anti-reflection film provided on the electromagnetic wave shielding film.

18. The front filter according to claim 17, wherein the electromagnetic wave shielding film is formed by a sputtering process.

19. The front filter according to claim 17, further comprising:
an adhesive layer provided at a second surface of the base film for bonding the base film to a release film.

20. The front filter according to claim 19, wherein the adhesive layer contains a dye for shielding near infrared rays and correcting colors.

21. The front filter according to claim 17, wherein the anti-reflection film has a smaller area than that of the electromagnetic wave shielding film.

22. A plasma display panel comprising:
upper and lower panels bonded to face each other with barrier ribs therebetween: and
a film type front filter formed on the upper panel, the front filter comprising a base film, an electromagnetic wave shielding film provided at a front surface of the base film, and an anti-reflection film provided on the electromagnetic wave shielding film.

23. The plasma display panel according to claim 22,
wherein the base film is made of glass, and the front filter is a glass type front filter.
